# EUROPEAN PATENT APPLICATION

(11) **EP 1 783 830 A1**
(43) Date of publication of application: **09.05.2007**
(21) Application number: 05753440.6
(22) Date of filing: 22.06.2005
(51) Int. Cl.: H01L 21/68, B25J 15/06, B65G 49/07

(54) **TRANSFER EQUIPMENT**

(30) Priority: 05.07.2004 JP 2004197512
(71) Applicant: Lintec Corporation, Tokyo 173-0001 (JP)
(72) Inventor: SAKAMOTO, Kazunori, LINTEC CORPORATION, Itabashi-ku Tokyo 1730001 (JP); KOBAYASHI, Kenji, LINTEC CORPORATION, Itabashi-ku Tokyo 1730001 (JP)
(74) Representative: Grünecker, Kinkeldey, Stockmair & Schwanhäusser Anwaltssozietät
(86) International application number: PCT/JP2005/011409
(87) International publication number: WO 2006/003820

(57) **Abstract**

A transfer unit 10 is structured including a supporting plate 11 having a supporting face 20A for a semiconductor wafer W, an arm plate 30 for supporting the supporting plate 11 and a parallelism adjuster 14 provided between the supporting plate and the arm plate 13. The supporting plate is arranged to be able to intake/discharge the air from the supporting face. Owing to the reaction when the supporting plate comes close to the semiconductor wafer W in the blowing state of the air, the supporting plate is maintained to be parallel with respect to the wafer. After coming close to the wafer in the state that the parallelism is maintained, the wafer is sucked and transferred.

## Description

### [Technical field]

The present invention relates to a transfer unit, in particular, to a transfer unit suitable for transferring a fragile plate-like object such as semiconductor wafer, which is polished to an extremely thin state, by sucking the same without giving any damage.

### [Background Art]

For a semiconductor wafer (hereinafter, simply referred to as "wafer") on which a circuit surface is formed, a series of processing are performed in a state having a protection tape on the circuit surface, such as sticking a heat sensitive adhesive sheet for die bonding to the rear surface side and then mounting to a ring frame. An apparatus for carrying out such a series of processing is disclosed in, for example, a Patent Document 1.

In the Patent Document 1, as an apparatus for transferring the wafer to each process, an arm type transfer unit is employed. The transfer unit is structured including a suction portion at the front-end side of the arm. The suction portion is arranged so as to suck a wafer to support and transfer the wafer to predetermined positions.

**[Patent Document 1]**
Japanese Patent Application Laid-open No. 2003-257898

### [Disclosure of the invention]

### [Problems to be Solved by the Invention]

However, in the structure disclosed in the Patent Document 1, such an arrangement is simply adopted that the front-end side of the arm is moved and the suction portion is pressed to the wafer to suck and hold when transferring the wafer. Therefore, there reside the following disadvantages.

That is, recent wafers are ground to a thickness of, for example, several dozens µm order. Therefore, in the case where an error in the parallelism between the supporting face of a supporting plate and the surface of the wafer, i.e., a minute inclination is generated, it may happen that a partial load is applied to the wafer when the supporting plate comes into contact with the surface of the wafer. Therefore, there arises such a specific disadvantage that the wafer is given a damage such as a crack, break or the like by this partial load. Further, it is extremely difficult to assemble the apparatus so that the parallelism of the supporting plate with respect to the wafer is maintained with a high precision. And furthermore, the precision of the component parts used for the purpose is strictly required, leading to a considerable cost impact.

### [Object of the invention]

The present invention has been proposed to solve the above disadvantages, while taking into consideration an aspect the problem that error or the like in assembly of the apparatus is unavoidable. It is an object of the present invention to provide a transfer unit capable of, when supporting a fragile plate-like object such as wafer with a supporting plate, adjusting the parallelism with respect to the plate-like object and creating a state of parallel contact to the plate-like object to support the same, and thereby preventing the damage of the plate-like object.

### [Means for Solving the problem]

In order to achieve the object, the present invention is arranged so that a transfer unit, including a supporting plate having a supporting face for supporting a plate-like object by sucking it, and holding members for holding the supporting plate, transfers the plate-like object to a predetermined position by sucking the plate-like object on the supporting face of the supporting plate, wherein
the supporting plate is arranged so as to be able to intake and blow out the air from the supporting face for the plate-like object, and is arranged so that the parallelism to the plate-like object is adjustable via a predetermined parallelism adjuster, wherein
the parallelism adjuster adjusts the parallelism between the supporting face and the plate-like object by blowing out the air toward the plate-like object from the supporting face of the supporting plate.

Also, the present invention is arranged so that a transfer unit, including a supporting plate having a supporting face for supporting a plate-like object by sucking it, and holding members for holding the supporting plate, transfers the plate-like object to a predetermined position by sucking the plate-like object on the supporting face of the supporting plate, wherein
the supporting plate is arranged so as to be able to intake and blow out the air substantially evenly within a plane from the supporting face for the plate-like object, and is arranged so that the parallelism to the plate-like object is adjustable via a predetermined parallelism adjuster, wherein
the parallelism adjuster is held by the holding members so that the parallelism with respect to the surface of the plate-like object is adjustable by the action of the air blown out from the supporting face when coming close to the plate-like object while the air is blown out from the supporting face.

In the present invention, the holding members include the supporting plate and an arm plate positioned substantially parallel to the supporting plate, and the parallelism adjuster is supported in a movable state in the direction substantially perpendicular to the surface of the arm plate so as not to fall off, and includes a supporting shafts of which one end is fixed to the surface of the side opposite to the supporting face of the supporting plate and spring members disposed around the supporting shafts between the supporting plate and the arm plate.

Also, the supporting shafts are arranged so as to extend through the arm plate, the shafts being capable to be inclined with respect to the surface of the arm plate.

Further, the supporting plate may be arranged so as to be able to adjust the temperature via a temperature control device.

Furthermore, the present invention may be arranged so that, by gradually reducing the blowing pressure of the air, the supporting plate comes slowly into contact with the plate-like object.

Still further, a semiconductor wafer is adopted as the plate-like object.

### [Advantage of the invention]

According to the present invention, the air is blown out to the plate-like object like a wafer to adjust the parallelism of the supporting plate. Therefore, even in a state such that the supporting plate is assembled with an error with respect to the holding member, the error is corrected and the parallelism between the supporting plate and the plate-like object is adjusted. Accordingly, there is no disadvantage such that, when the supporting plate comes into contact with the plate-like object, a partial stress is given to the plate-like object; thus, damages like a crack can be prevented efficiently.

Moreover, since the air is blown out to the plate-like object, even when the plate-like object itself includes a minute warp or deformation, the warp or deformation can be corrected. In this point also, the cause of damage of the plate-like object can be eliminated.

Furthermore, according to the arrangement in which the spring members are disposed around the supporting shafts for holding the supporting plate with the holding member, after terminating the blowing out the air, the supporting plate is depressed toward the plate-like object side to achieve the contact therewith. Therefore, the relative movement to come close to each other immediately before the supporting plate comes into contact with the plate-like object can be carried out by the spring force. Accordingly, the supporting plate can be brought into contact with the plate-like object without requiring complicated control of cylinders or the like.

Still further, the supporting plate is arranged so as to be able to adjust the temperature. Accordingly, when the temperature control of the plate-like object is required, the temperature control can be carried out while transferring the same, which contributes the time reduction for temperature control operation.

Still furthermore, when such an arrangement is adopted that the blowing pressure of the air is gradually reduced so that the supporting plate slowly comes into contact with the plate-like object, at a point when the supporting plate comes into the plate-like object, the depressing force by the spring members acts on the supporting plate in a buffered state. In this point also, damages to the plate-like object can be prevented.

### [Brief Description of the Drawings]

[Fig. 1]

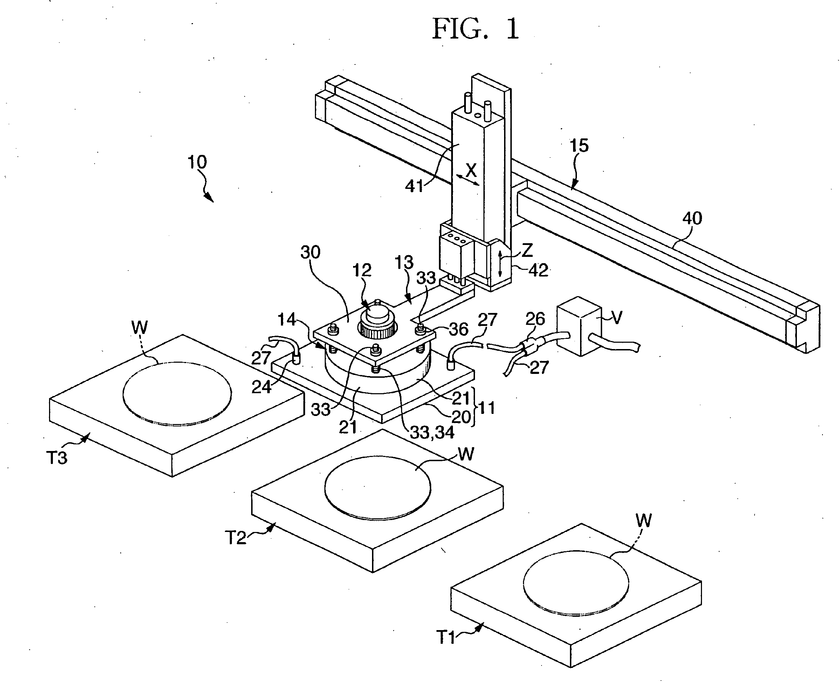

   Fig. 1 is a perspective view schematically showing the entire structure of a wafer transfer unit in accordance with an embodiment of the present invention.
[Fig. 2]

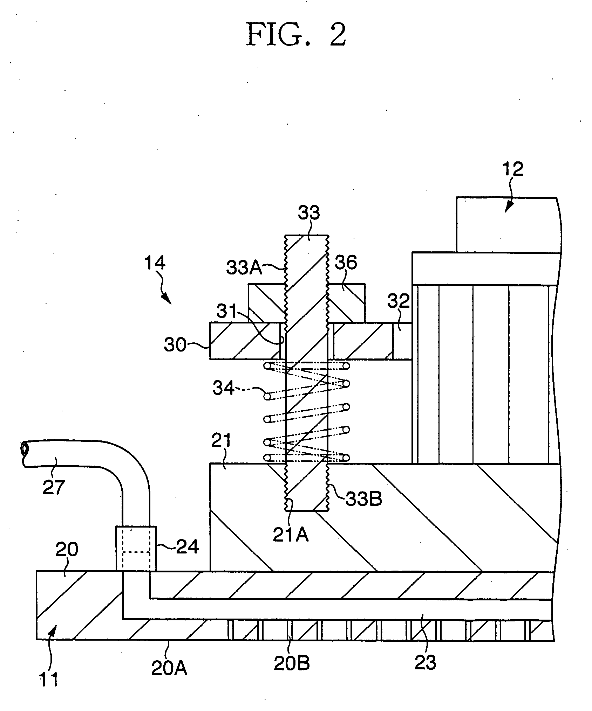

   Fig. 2 is an enlarged sectional view of an essential portion shown in Fig. 1.
[Fig. 3]

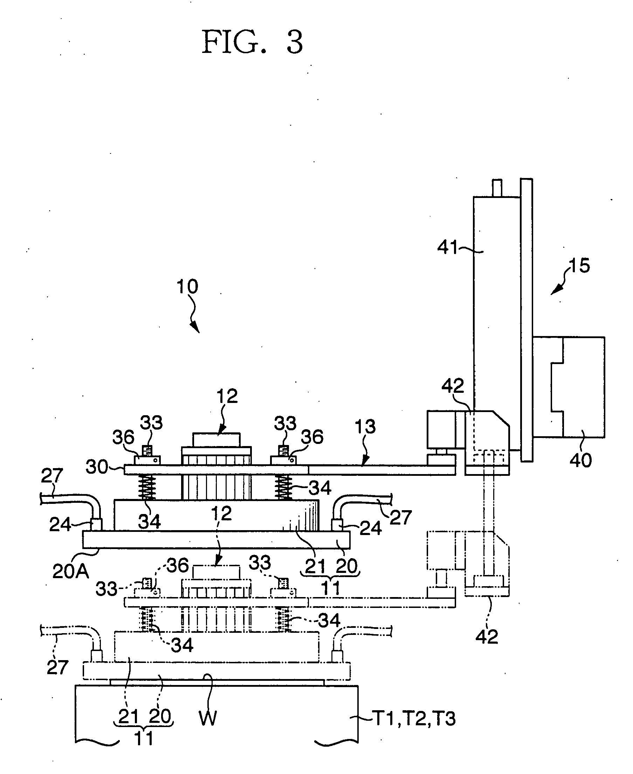

   Fig. 3 is a side view of the transfer unit.
[Fig. 4]

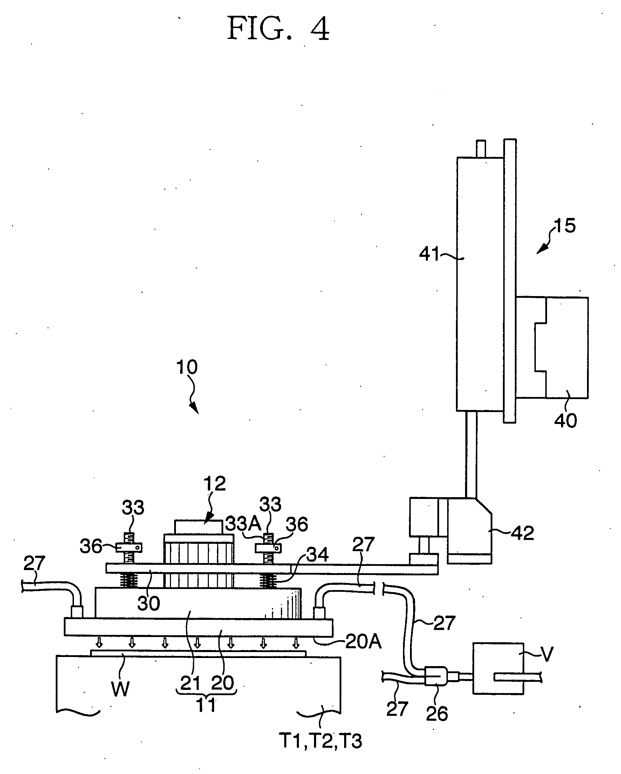

   Fig. 4 is a side view of the transfer unit showing a state immediately before the supporting plate sucks a wafer to support the same.
[Fig. 5]

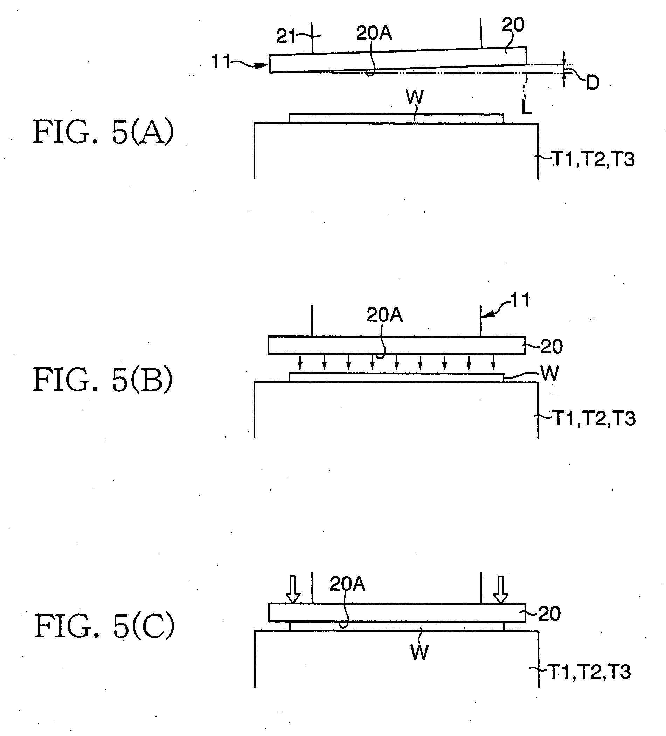

   Figs. 5(A) to 5(C) are views for illustrating the operation of the embodiment.

### [Explanation of reference numerals]

- 10: transfer unit
- 11: supporting plate
- 13: holding member
- 14: parallelism adjuster
- 20: lower plate
- 20A: supporting face
- 20B: air intake/discharge holes
- 30: arm plate
- 33: supporting shaft
- 34: coil spring (spring member)
- W: semiconductor wafer (plate-like object)
- T1, T2, T3: table

### [Best Mode for Carrying Out the Invention]

Hereinafter, an embodiment of the present invention will be described with reference to the drawings.

Fig. 1 schematically shows the structure of a transfer unit in accordance with an embodiment of the present invention. Referring to Fig. 1, a transfer unit 10 is structured including a supporting plate 11 for a wafer W as a plate-like object, a temperature control device 12 that controls the temperature of the supporting plate 11, a holding member 13 that, holds the supporting plate 11, a parallelism adjuster 14 disposed between the supporting plate 11 and the holding member 13, and a shifter 15 that moves the supporting plate 11 in the X and Z-directions in Fig. 1.

Below the supporting plate 11, first to third tables T1, T2 and T3 are disposed, and the transfer unit 10 is structured so as to transfer the wafer W between the tables T1 to T3. Although detailed description of the tables T1 to T3 is omitted, each table is structured including a device for controlling the temperature of the wafer W to a predetermined temperature and a device for shifting the table position in the vertical or horizontal directions, if necessary.

As shown in Fig. 2 to Fig. 4, the supporting plate 11 is structured including a lower plate 20 of a substantially square shape viewed from the top and an upper plate 21 of a substantially disk-like shape. The bottom face side of the lower plate 20 is formed as a supporting face 20A for the wafer W. Within the lower plate 20, a path 23 extending in substantially horizontal direction is formed, and in the midway of the path 23, many air intake/discharge holes 20B communicating with the supporting face 20A are formed at regular intervals having substantially same sizes. The lower plate 20 may be formed of a porous material. The both ends of the path 23 communicate with connecting portions 24 having a pipe-like shape formed at two points adjacent to the corners on the upper face side of the lower plate 20. To each of the connecting portions 24, one end of a hose 27, which is led out from a branch portion 26 provided to an intake/discharge switching valve V (refer to Fig. 1) using a vacuum ejector, is connected.

The temperature control device 12 is disposed in substantially central portion of the upper plate 21; and a well-known structure is employed therefor. The temperature control device 12 is provided with a heating function and cooling function of the supporting plate 11; and is arranged so as to heat/cool down the wafer W sucked by the lower plate 11 depending on the necessity.

The holding member 13 includes an arm plate 30 positioned substantially parallel to the supporting plate 11. The arm plate 30 is formed in a substantially square shape at the front-end side (left end side in Fig. 1), having through holes 31 (refer to Fig. 2) formed adjacent to each corner; and in the central area thereof, a central hole 32 for receiving the upper portion of the temperature control device 12 is formed having the inside diameter thereof slightly larger than the periphery of the temperature control device 12.

The parallelism adjuster 14 is structured including supporting shafts 33, which are inserted freely within the through holes 31 so as to be in the direction substantially perpendicular to the surface of the arm plate 30, and coil springs 34 as spring members disposed around the supporting shafts 33 between the supporting plate 11 and the arm plate 30. The supporting shaft 33 has a bolt-like shape, and at least on the periphery surface in the upper end area thereof, male screw portion 33A is formed. A nut member 36 is screwed with the male screw portion 33A in a state that the male screw portion 33A is inserted through the through hole 31 from the bottom. Owing to this, the supporting shaft 33 is supported movably in the direction substantially perpendicular to the surface of the arm plate 30 (vertical direction in Fig. 2) in a state that, the supporting shaft 33 is prevented from falling off. Here, being inserted freely within the through hole 31, the supporting shaft 33 is allowed to incline with respect to the arm plate 30. The lower end of the supporting shaft 33 is fixed to the upper face side of the upper plate 21, which is the side opposite to the supporting face 20A of the lower plate 20. Fixing of the shafts 33 to the plate 21 is achieved in this embodiment by screwing the male screw 33B, which is formed in the lower end portion of the supporting shaft 33, into the female screw portion 21A, which is formed in the upper plate 21.

The coil springs 34 are provided in a state being interposed between the supporting plate 11 and the arm plate 30 so as to depress the supporting plate 11 downward. The coil spring 34 is arranged so that compressed to allow the supporting plate 11 to come closer to the arm plate 30 when an upward force is given with respect to the supporting face 20A of the supporting plate 11.

As shown in Fig. 1, the shifter 15 is structured including a single shaft robot 40, which is disposed substantially in the horizontal direction, a cylinder 41, which is provided movably along the extending direction (X-direction) of the single shaft robot 40 and extends in the direction perpendicular to the vertical direction, and a lifting slider 42 movably in the Z-direction via the cylinder 41. The base end side (right end side in Fig. 1) of the arm plate is connected to the lifting slider 42.

Next, referring to the drawings including Fig. 5, the transferring method of the wafer W in the embodiment will be described.

Here, it is assumed that, as shown Fig. 1, the position where the supporting plate 11 is positioned above the second table T2 is the initial position; and that a wafer W set on the second table 2 is sucked and transferred to a first or third table T1 or T3.

As shown in Fig. 3, the supporting plate 11 of the transfer unit 10 is positioned at a waiting position above the wafer W. When an instruction to suck the wafer W is given from an unshown control device, the cylinder 41 is activated and the lifting slider 42 begins to descend. Owing to the descent of the lifting slider 42, when the suction face 20A in the lower plate 20 of the supporting plate 11 comes closer to the wafer W, the air intake/discharge switching valve V is driven and the air is blown out from the air intake/discharge holes 20B. Note that the blowing operation of the air may be started at a point of time when the descent of the lifting slider 42 starts.

Here, assuming that, as show in Fig. 5(A), due to an attachment error of the supporting plate 11 with respect to the arm plate 30, a slight inclination of the suction face 20A is generated with respect to a virtual line L parallel to the surface of the wafer W; and that the supporting plate 11 descends while including a height difference D, the supporting face 20A comes into contact with a portion of the wafer W (left side in Fig. 5(A)) with the height difference D retained, which results in stress concentration.

In this embodiment, as shown in Fig. 5(B), when the supporting face 20A comes closer to the wafer W; for example, when the supporting face 20A comes close to the wafer W up to approximately 0.1 mm, owing to the reaction of the discharged air blown out from the air intake/discharge holes 20B; i.e., the discharged air is reflected at the surface of the wafer W, and generates a force to lift up the supporting plate 11. When the lifting force acts on the supporting plate 11, the supporting plate 11 rises against the depressed force of the coil spring 34. Accompanying the rising of the supporting plate 11, the supporting shafts 33 change the inclination within the through holes 31; thus, the supporting face 20A is made to coincide with the virtual line L and the parallelism is adjusted.

When the blowing of the air is stopped in this state, owing to the depressed force of the coil spring 34, the supporting plate 11 comes into contact with the entire area of the wafer W simultaneously while maintaining the parallelism. Then, the intake/discharge operation of the intake/discharge switching valve V is switched to start the intake operation of the air through the air intake/discharge holes 20B, the wafer W is sucked and supported by the supporting face 20A. By driving the shifter 15 while sucking and supporting the wafer W, the wafer W can be transferred to the neighboring table T1 or T3. In the case where there resides an attachment error in the supporting plate 11 as described above, the supporting face 20A of the supporting plate 11 becomes an inclined state with respect to the virtual line L even for the upper face of the table at the receiving side as well. However, the pressure generated when the supporting plate 11 comes into contact with the wafer W to suck the same, can be controlled not to be generated. That is, the sucking operation is stopped at a position where the pressurizing force is not applied to the surface of the table at the receiving side. Therefore, it is not necessary to take the crack or the like of the wafer W into consideration. Also, such an arrangement may be possible that, air intake/discharge holes are formed in each surface of the tables supporting the wafer W in the same manner as the supporting plate 11; and when receiving the transferred wafer, the air is blown out against the wafer W sucked and supported by the supporting plate 11; thus the transfer can be carried out while adjusting the parallelism causing substantially the same effect as the above-described one.

Therefore, according to the embodiment of the present invention, it is possible to provide a transfer unit, which takes outstanding effects never achieved by the conventional art. That is, in addition to the advantage that the wafer W can be transferred while eliminating the causes to damage the wafer W, the temperature of the wafer W can also be adjusted simultaneously while transferring the wafer.

The best structure and method for carrying out the present invention have been disclosed so far. However, the present invention is not limited to the above.
That is, the present invention has been illustrated and described about mainly a specific embodiment. However, if necessary, it is possible for a person skilled in the art to add various modifications to the above-described embodiment with respect to the shape, position or disposition without departing from the technical spirit and the range of the object of the present invention.

For example, in the above embodiment, there has been illustrated and described as the structure in which the transfer unit 10 moves to transfer the wafer W between the tables T1 to T3. However, such structure that the table T1 to T3 side moves to transfer the wafer W may be employed.

Also, the parallelism adjuster 14 in the present invention is not limited to the structure of this embodiment. For example, it may be arranged in such a way that an air compressor cylinder is provided between the supporting plate 11 and the arm plate 30, and the length of the cylinder is expanded and compressed by the reaction of the discharged air blown out from the air intake/discharge holes 20B. In other words, as for the parallelism adjuster 14 in the present invention, it is sufficient to have what can adjust the supporting face 20A of the supporting plate 11 to be parallel to the wafer W using the blown out air. Further, the following arrangement is employed in the invention; i.e., after adjusting the parallelism of the supporting plate 11, the blowing of the air from the air intake/discharge hole 20B is stopped, and the supporting plate 11 is allowed to come into contact with the wafer W by means of the depressed force of the coil spring. However, such a control method may be employed that the blowing out of the air is gradually weakened and is terminated finally so that the operation to bring the supporting plate 11 into contact with the wafer W can be carried out slowly.

Further, the object to be sucked is not limited to the wafer W, but a fragile plate-like object such as glass may be the object.

## Claims

1. A transfer unit, including a supporting plate having a supporting face for supporting a plate-like object by sucking it, and holding members for holding the supporting plate, that transfers said plate-like object to a predetermined position by sucking the plate-like object on the supporting face of said supporting plate, wherein
said supporting plate is arranged so as to be able to intake and blow out the air from the supporting face for said plate-like object, and is arranged so that the parallelism to said plate-like object is adjustable via a predetermined parallelism adjuster, wherein
said parallelism adjuster adjusts the parallelism between the supporting face and the plate-like object by blowing out the air toward said plate-like object from the supporting face of said supporting plate.

2. A transfer unit, including a supporting plate having a supporting face for supporting a plate-like object by sucking it, and holding members for holding the supporting plate, that transfers said plate-like object to a predetermined position by sucking the plate-like object on the supporting face of said supporting plate, wherein
said supporting plate is arranged so as to be able to intake and blow out the air substantially evenly within a plane from the supporting face for said plate-like object, and is arranged so that the parallelism to said plate-like object is adjustable via a predetermined parallelism adjuster, wherein
said parallelism adjuster is held by said holding members so that the parallelism with respect to the surface of the plate-like object is adjustable by the action of the air blown out from the supporting face when coming close to the plate-like object while the air is blown out from said supporting face.

3. The transfer unit according to claims 1 or 2, wherein
said holding members include said supporting plate and an arm plate positioned substantially parallel to said supporting plate,
said parallelism adjuster is supported in a movable state in the direction substantially perpendicular to the surface of said arm plate so as not to fall off , and includes supporting shafts of which one end is fixed to the surface of the side opposite to the supporting face of said supporting plate and spring members disposed around the supporting shafts between said supporting plate and the arm plate.

4. The transfer unit according to claim 3, wherein said supporting shafts extend through the arm plate, the shafts being capable to be inclined with respect to the surface of said arm plate.

5. The transfer unit according to any of claims 1 to 4, wherein said supporting plate is arranged so as to be able to adjust the temperature via a temperature control device.

6. The transfer unit according to any of claims 1 to 5, wherein, by gradually reducing said blowing pressure of the air, said supporting plate comes slowly into contact with said plate-like object.

7. The transfer unit according to any of claims 1 to 5, wherein said plate-like object is a semiconductor wafer.
